Europäisches Patentamt

European Patent Office

Office européen des brevets

(19)

(11) Publication number: **0 029 369**
**B1**

(12) **EUROPEAN PATENT SPECIFICATION**

(45) Date of publication of patent specification: **04.02.87**

(51) Int. Cl.⁴: **H 01 L 27/02, H 01 L 29/08**

(21) Application number: **80304117.7**

(22) Date of filing: **18.11.80**

(54) **A method of manufacturing a semiconductor device.**

(30) Priority: **20.11.79 JP 150307/79**

(43) Date of publication of application:
**27.05.81 Bulletin 81/21**

(45) Publication of the grant of the patent:
**04.02.87 Bulletin 87/06**

(84) Designated Contracting States:
**DE FR GB**

(56) References cited:
**US-A-3 895 977**

**IBM TECHNICAL DISCLOSURE BULLETIN, vol.
20, no. 9, February 1978, pages 3507-3508, New
York (USA); M. VERHAEGHE: "General
purpose master slice"**

(73) Proprietor: **FUJITSU LIMITED**
**1015, Kamikodanaka Nakahara-ku
Kawasaki-shi Kanagawa 211 (JP)**

(72) Inventor: **Enomoto, Hiromu**
**No. 1-15-1225, Kawara-cho, Saiwai-ku
Kawasaki-shi, Kanagawa, 210 (JP)**
Inventor: **Yasuda, Yasushi**
**No. 92-2, Ohmaru, Inagi-shi
Tokyo, 192-02 (JP)**
Inventor: **Mitono, Yoshiharu**
**No. 1-14-12, Sakuragaoka, Setagaya-ku
Tokyo, 156 (JP)**
Inventor: **Imaizumi, Taketo**
**No. 449, Koueki, Sue-cho, Kasuya-gun
Fukuoka, 811-21 (JP)**
Inventor: **Ohmichi, Hitoshi**
**No 202, Shukugawara Tama-ku
Kawasaki-shi, Kanagawa 214 (JP)**

(74) Representative: **Bedggood, Guy Stuart et al
Haseltine Lake & Co. Hazlitt House 28
Southampton Buildings Chancery Lane
London WC2A 1AT (GB)**

Courier Press, Leamington Spa, England.

## Description

The present invention relates to a method of manufacturing a semiconductor device.

The master slice method, which is one method used for manufacturing LSI's or like semiconductor devices, is a method in which a common master pattern is employed in the manufacturing process from a starting step to a diffusion step to form transistors, resistors and other elements in a substrate and in which the circuit elements so formed are wired in a particular pattern selected in accordance with a semiconductor device ultimately desired to be obtained. With such a master slice method, in the production of LSI's, especially in a case in which many kinds of LSI's are manufactured in small quantities, manufacturing costs and times can be reduced since one part of the manufacturing process is common to all of the different kinds.

Generally, in the formation of circuits it is often required to provide a predetermined current ratio between a plurality of semiconductor elements.

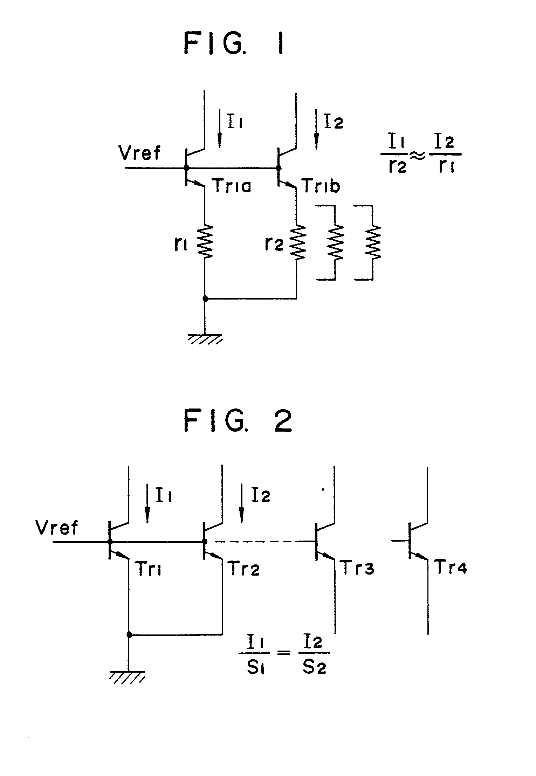

To meet such a requirement, for obtaining a predetermined current ratio through utilization of semiconductor elements of the same characteristics, it is considered possible to connect resistors $r_1$ and $r_2$ of different values to transistors $Tra_{1a}$ and $Tra_{1b}$ respectively, as shown in Figure 1 of the accompanying drawings, which is a schematic circuit diagram. Letting currents flowing in the transistors $Tra_{1a}$ and $Tra_{1b}$ be represented by $I_1$ and $I_2$, respectively, there exists a relationship, $I_1/r_2 \approx I_2/r_1$.

In a case in which it is intended to obtain the predetermined current ratio by changing the currents flowing in the transistors $Tra_{1a}$ and $Tra_{1b}$ of the same characteristics by using the resistors, as described above, however, the emitter current densities of the transistors are different, so that transistor $Tra_{1a}$ or transistor $Tra_{1b}$ operates at a point different from its normal operating point and the temperature dependencies of the base-to-emitter voltages $V_{BE}$ of the transistors are different, resulting in the preset current ratio varying with temperature.

A remedy for such a defect is the employment of transistors of different emitter areas. Assuming that transistors $Tr_1$, $Tr_2$, $Tr_3$, $Tr_4$...shown in Figure 2 of the accompanying drawings, which is a schematic circuit diagram, have different emitter areas $S_1$, $S_2$, $S_3$, $S_4$,..., respectively, it follows that

$$\frac{I_1}{S_1} = \frac{I_2}{S_2}$$

where $I_1$, $I_2$, ... are the currents flowing in the transistors $Tr_1$, $Tr_2$, .... In such a case, it is possible to provide a required current ratio between adjacent transistors and to retain the emitter current density of each transistor constant; accordingly, the transistors operate in their normal mode of operation and do not suffer characteristic variations due to temperature effects.

Now, a description will be given of the manufacture of an integrated circuit device including such transistors of different emitter areas according to the master slice method. For facilitating a better understanding of the description, there will be described a situation in which three different kinds of LSI (semiconductor devices) each comprising 10 transistors and based on three kinds of bipolar transistor structures $Tr_1$, $Tr_2$ and $Tr_3$ whose emitter areas are in the ratio 1 to 2 to 3, are manufactured by the master slice method. With their emitter areas selected in the ratio of 1 to 2 to 3, the bipolar transistor structures exhibit different characteristics (when wired) for example, in that their collector voltage ratio relative to the same base-emitter voltage $V_{BE}$ is 1 to 2 to 3.

With the master slice method, the same master pattern is used for each of a plurality of different kinds of LSI's; in the present case it is necessary to prepare a master pattern including ten of each of the three kinds of bipolar transistor structures $Tr_1$, $Tr_2$ and $Tr_3$.

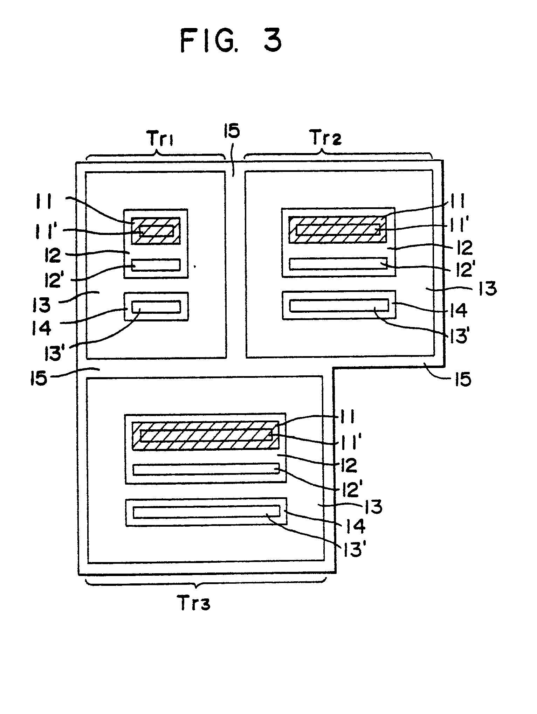

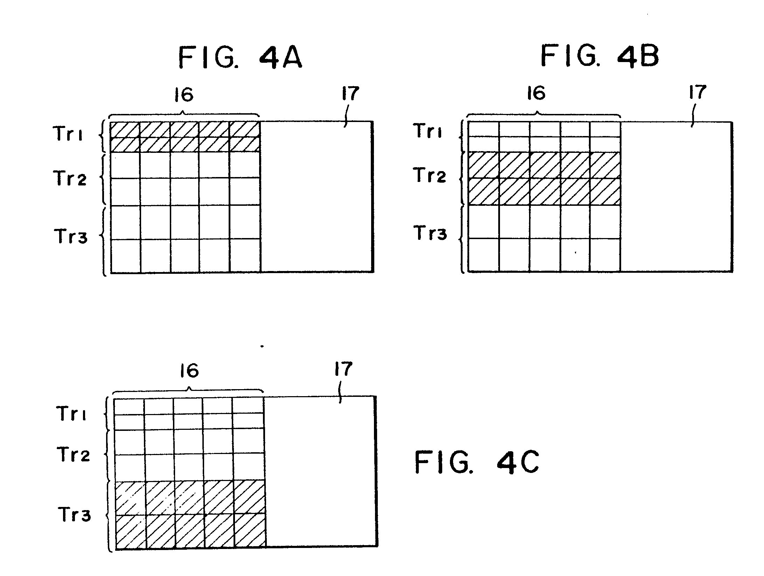

Figure 3 of the accompanying drawings, which is a schematic plan view, shows a pattern giving each of the three kinds of bipolar transistor structures $Tr_1$, $Tr_2$ and $Tr_3$. In Figure 3, the hatched parts are the emitter regions 11 of the transistor structures, and the areas of the emitter regions of bipolar transistor structures $Tr_1$, $Tr_2$ and $Tr_3$ are selected in the ratio 1 to 2 to 3. Reference numeral 12 indicates base regions; 13 designates collector regions, 14 identifies collector contact regions; 11', 12' and 13' denote contact holes for the respective regions; and 15 represents an isolation region for isolating each of the transistor structures from the others. Figures 4A to 4C of the accompanying drawings are schematic plan views explanatory of this example, schematically illustrating master patterns. In Figures 4A, 4B and 4C, each part indicated by reference numeral 16 is a region in which are prepared ten of each of the three kinds of bipolar transistor structures $Tr_1$, $Tr_2$ and $Tr_3$. Each part indicated by reference numeral 17 is a region prepared for functions other than the bipolar transistor structures $Tr_1$, $Tr_2$, $Tr_3$. Each hatched part region indicates the bipolar transistor structures which are interconnected in a subsequent wiring step and put to practical use. In Figure 4A, 10 bipolar transistor structures $Tr_1$ are put to use, and in Figures 4B and 4C bipolar transistor structures $Tr_2$ and $Tr_3$ are similarly put to use in tens, respectively.

As will be seen from Figure 4, although in this example ten of each of the three kinds of bipolar transistor structure $Tr_1$, $Tr_2$ and $Tr_3$ are prepared, only some of them are actually put to use, leaving the others unused. This is wasteful.

US—A—3 895 977 discloses the provision of bipolar transistor structures of different current capacities, which have base diffusion areas of respective different sizes and which have emitters of respective different total areas.

In each bipolar transitor structure the emitter is made up of a number of emitter diffusion areas each of the same shape and size (the total number of such emitter diffusion areas being selected in accordance with the desired current capacity). All the emitter diffusion areas are interconnected in the finished structure.

According to the present invention there is provided a method of manufacturing a plurality of semiconductor devices in which respective pluralities of bipolar transistor structures are formed on respective semiconductor substrates of the devices in accordance with a master slice method using a master pattern common to all the devices, and in which the transistor structures of the respective devices are selectively wired in accordance with respective different wiring patterns, to provide that the devices are each of a different kind, characterised in that the transistor structures are all the same, having base regions of the same shape and having each a plurality of emitter regions of the same number, the base and emitter regions of the respective transistor structures being formed using the same master pattern, and in that each of the different wiring patterns connects up a respective selected number including zero of the emitter regions of each transistor structure of the device to which the wiring pattern relates.

An embodiment of the present invention provides a method for the manufacture of semiconductor devices whereby when providing a region for the formation of bipolar transistors of different characteristics in a common master pattern, the ratio of the region occupied by bipolar transistors to be actually used to the region provided for all transistors formed is increased, to reduce useless regions in the master pattern, thereby improving its area efficiency.

Thus, an embodiment of the present invention offers an improved method for manufacturing an integrated circuit device including bipolar transistors by a master slice method.

Briefly stated, according to an embodiment of the present invention, a plurality of semiconductor devices of various kinds, in each of which a predetermined DC characteristic is set up among a plurality of bipolar transistors and the emitter current densities of the bipolar transistors are held substantially the same, are manufactured by the master slice method through utilization of a common master pattern and required kinds of wiring patterns. A number of bipolar transistor portions having respectively a plurality of emitter regions are formed by the common master pattern in a semiconductor substrate; and the bipolar transistors of different DC characteristics are formed by the wiring patterns, selecting the number of emitter regions required for each particular semiconductor device.

Reference is made, by way of example, to the accompanying drawings, in which:—

Figure 1, as mentioned above, is a circuit diagram explanatory of a prior art example;

Figure 2, as mentioned above, is a circuit diagram explanatory of another prior art example;

Figure 3, as mentioned above, is a schematic plan view showing principal parts of a semiconductor device produced according to the prior art;

Figures 4a, 4B and 4C are schematic plan views explanatory of the semiconductor device shown in Figure 3;

Figure 5 is a schematic circuit diagram explanatory of the present invention;

Figure 6 is an equivalent circuit diagram of principal parts of a semiconductor device produced according to an embodiment of the present invention;

Figure 7 is a schematic plan view of principal parts of the semiconductor device produced according to an embodiment of the present invention;

Figures 8A, 8B and 8C are schematic plan views of principal parts of semiconductor devices produced according to an embodiment of the present invention; and

Figure 9 is a schematic plan view for assistance in explanation of the high area efficiency of the semiconductor device produced according to an embodiment of the present invention.

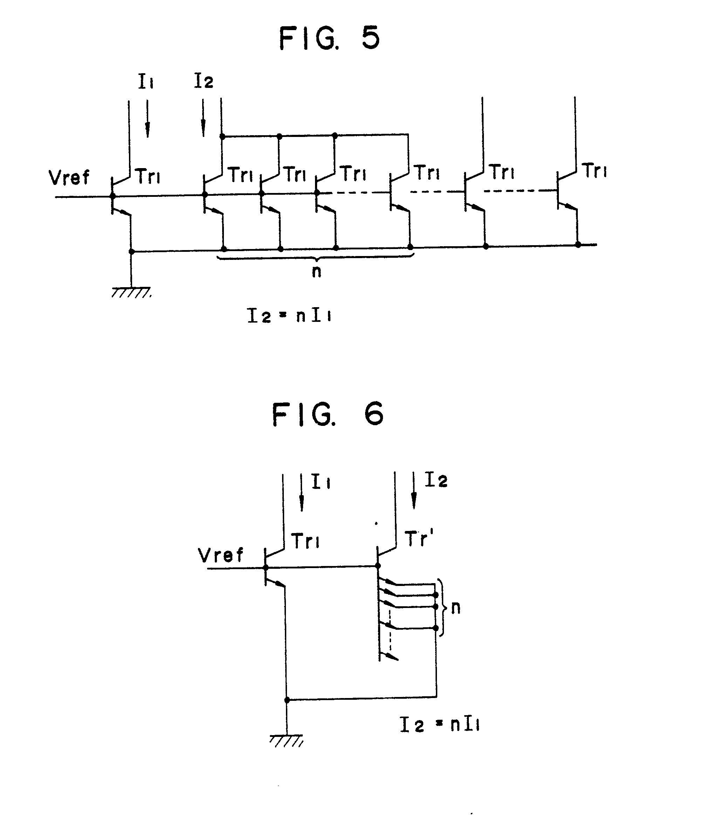

The present invention rests on the idea that a plurality of transistor structures $Tr_1$ of the same emitter area and the same characteristics are prepared and then selectively connected (in a wiring step) in parallel in accordance with a required current ratio, as shown in Figure 5. Letting the number of transistor structures $Tr_1$ connected in parallel be represented by n, $I_2 = nI_1$, where $I_1$ and $I_2$ are currents.

With such an arrangement, area efficiency is excellent as compared with the area efficiency obtainable with the prior art examples described previously with reference to Figures 3 and 4.

Even higher area efficiency can be obtained by employing, for a transistor $Tr'$, a multi emitter transistor structure having a plurality of emitters, for example of the same areas, and connecting the emitters in parallel as required, as shown in Figure 6. In an embodiment of the present invention semiconductor devices including such a transistor structure as shown in Figure 6 are produced by the master slice method. In Figure 6, letting the number of emitters connected in parallel be represented by n, $I_2 = nI_1$.

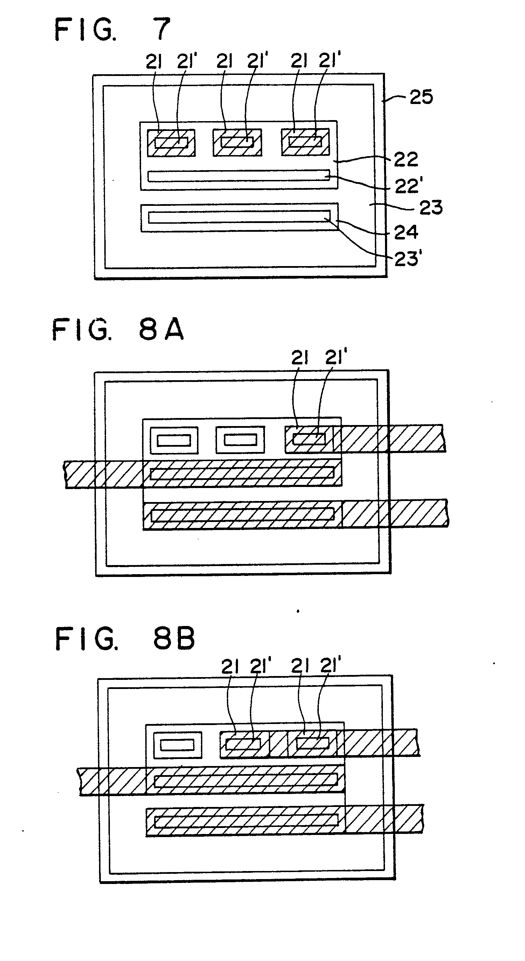

A detailed description will hereinafter be given, with reference to Figure 7 et seq, of an embodiment of the present invention. For a better understanding the embodiment will be described as applied to the same situation as that in connection with which the prior art was described.

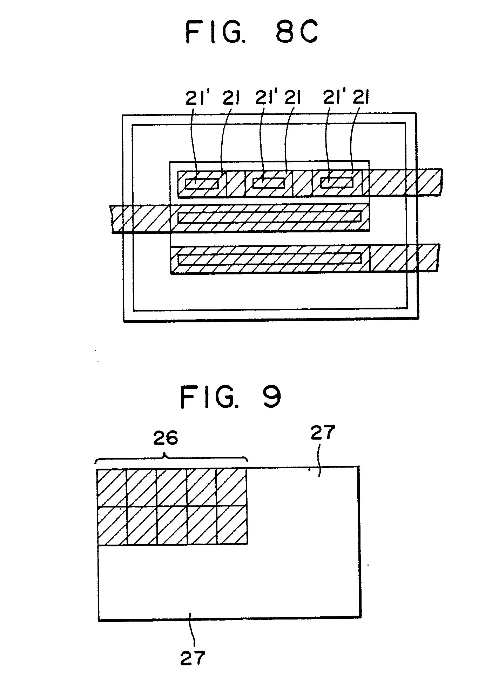

According to the present embodiment, for obtaining three kinds of bipolar transistors which have an emitter area ratio of 1 to 2 to 3, use is made of a single bipolar transistor structure of such a pattern as shown in Figure 7. In Figure 7, reference numeral 21 indicates emitter regions (hatched portions), each of which has the same area as the emitter region 11 of the bipolar transistor $Tr_1$ shown in Figure 3, three emitter regions being provided in all; 22 designates a base region; 23 identifies a collector region; 24 denotes a collector contact region; 21', 22' and 23' represent contact holes for the respective regions; and 25 shows an isolation region. Figures 8A, 8B and 8C respectively illustrate bipolar transistors bearing an emitter area ratio of 1 to 2 to 3, produced by employing different wiring patterns in otherwise similar bipolar transistor structures formed to the pattern of Figure 7. The hatching indicates wiring patterns. In Figure 8A one emitter region 21 is used and in Figures 8B and 8C, two and three emitter regions are used respectively. Of course, in a given device, one or more of the transistor structures may be entirely superfluous, in which case the number of emitter regions of that structure which are used is zero. The areas occupied by the bipolar transistor structures of Figures 7 and 8A to 8C are larger than the area occupied by each bipolar transistor structure ($Tr_1$ or $Tr_2$ or $Tr_3$) of Figure 3 but smaller than the sum of the individual areas occupied by the three bipolar transistor structures $Tr_1$, $Tr_2$ and $Tr_3$ of Figure 3 (about one-half in this embodiment).

When three different kinds of LSI, which are based on three kinds of transistors employed in tens are manufactured in accordance with an embodiment of the present embodiment, the bipolar transistors are formed as shown in Figure 9. In other words, according to the present embodiment, since a plurality of kinds of bipolar transistors can be obtained from the one pattern as shown in Figure 7, it is sufficient only to provide in the master pattern ten bipolar transistor structures of the present embodiment as depicted in Figure 7; accordingly, the region required for the bipolar transistors is smaller than the region needed in the prior art (about one-half in this embodiment). In Figure 9, reference numeral 26 indicates the region used for the bipolar transistors, which are actually used; and 27 designates the other region.

As has been described above, according to the present invention, a plurality of kinds of bipolar transistor of different characteristics can be obtained by employing different wiring patterns for wiring bipolar transistor structures formed by a common master pattern. Accordingly, in the manufacture of a plurality of kinds of semiconductor devices (such as LSI's) having bipolar transistors of different characteristics by the master slice method using a common master pattern, the region required in the master pattern for the formation of the bipolar transistor structures is reduced as compared with the region needed in the prior art; hence, it is possible to produce semiconductor devices of excellent area efficiency.

Thus, an embodiment of the present invention concerns a method for manufacturing semiconductor devices, using the master slice method, in which various kinds of semiconductor devices are manufactured through utilization of a common master pattern and a plurality of kinds of wiring patterns. A number of bipolar transistor structures, each having a plurality of similar emitter regions are formed by the common master pattern in a semiconductor substrate. The emitter regions of the plurality in a bipolar transistor structure can be selectively used by the wiring patterns to form bipolar transistors of different DC characteristics. When manufacturing many kinds of semiconductor devices by this method, the area of the semiconductor substrate which is wasted is greatly reduced, thus providing for enhanced area efficiency.

Also, a basic aspect of this invention provides a method of manufacturing a semiconductor device in which a plurality of bipolar transistor structures are formed on a semiconductor substrate, and in which the transistor structures are selectively wired, in accordance with a wiring pattern required to provide a device of the desired kind, characterised in that the transistor structures are all the same, and in that the wiring pattern is such as to connect up selected numbers of the transistor structures in parallel.

Devices of different kinds are manufactured by forming respective pluralities of bipolar transistor structures, all the same, on respective substrates of the devices in accordance with a master slice method using a master pattern in common to all the devices, and using different wiring patterns for the devices.

**Claims**

1. A method of manufacturing a plurality of semiconductor devices in which respective pluralities of bipolar transistor structures are formed on respective semiconductor substrates of the devices in accordance with a master slice method using a master pattern common to all the devices, and in which the transistor structures of the respective devices are selectively wired in accordance with respective different wiring patterns, to provide that the devices are each of a different kind, characterised in that the transistor structures are all the same, having base regions (22) of the same shape and having each a plurality of emitter regions (21) of the same number, the base (22) and emitter regions (21) of the respective transistor structures being formed using the same master pattern, and in that each of the different wiring patterns connects up a respective selected number including zero of the emitter regions (21) of each transistor structure of the device to which the wiring pattern relates.

2. A method as claimed in claim 1, wherein the emitter regions (21) are all of equal area.

3. A method as claimed in claim 1 or 2, wherein respective predetermined DC characteristics are provided for transistors of the respective devices, when the transistor structures of the respective devices are wired, and such that respective emitter current densities of the transistors of respective devices are substantially the same when the devices are in use.

## Patentansprüche

1. Verfahren zur Herstellung einer Vielzahl von Halbleitervorrichtungen, bei welchem entsprechende Vielzahlen von bipolaren Transistorstrukturen auf entsprechenden Halbleitersubstraten der Vorrichtungen in Übereinstimmung mit einem Mutterschneideverfahren gebildet werden, welches ein Muttermuster verwendet, das allen Vorrichtungen gemeinsam ist, und bei welchem die Transistorstrukturen der entsprechenden Vorrichtungen selektiv in Übereinstimmung mit entsprechend verschiedenen Verdrahtungsmustern verdrahtet werden, um vorzusehen, daß die Vorrichtungen jeweils von einer verschiedenen Art sind, dadurch gekennzeichnet, daß die Transistorstrukturen alle dieselben sind und Basisbereiche (22) von derselben Form halben und jeweils eine Vielzahl von Emitterbereichen (21) von derselben Anzahl haben, die Basis-(22)- und Emitterbereiche (21) de entsprechenden Transistorstrukturen unter Verwendung desselben Muttermusters gebildet werden, und daß jedes der verschiedenen Verdrahtungsmuster eine entsprechend ausgewählte Anzahl, einschließlich Null, von Emitterbereichen (21) von jeder Transistorstruktur der Vorrichtung, zu welcher das Verdrahtungsmuster gehört, miteinander verbindet.

2. Verfahren nach Anspruch 1, bei welchem die Emitterbereiche alle von gleicher Fläche sind.

3. Verfahren nach Anspruch 1 oder 2, bei welchem entsprechend vorbestimmte Gleichstrom - Charakteristiken für Tansistoren von entsprechenden Vorrichtungen vorgesehen sind, wenn die Transistorstrukturen der entsprechenden Vorrichtungen verdrahtet werden, und so, daß entsprechende Emitterstromdichten der Transistoren der entsprechenden Vorrichtungen im wesentlichen dieselben sind, wenn die Vorrichtungen in Betrieb sind.

## Revendications

1. Procédé de fabrication d'une pluralité de dispositifs semiconducteurs, dans lequel on forme des pluralités respectives de structures de transistor bijonction sur des substrats semiconducteurs respectifs des dispositifs selon un procédé de la matrice standard utilisant une configuration de matrice commune pour tous les dispositifs, et dans lequel on câble sélectivement les structures de transistor des dispositifs respectifs suivant des configurations de câblage respectives différentes, afin d'obtenir que les dispositifs soient chacun d'un type différent, caractérisé en ce que les structures de transistor sont toutes identiques, possédant des régions de base (22) qui ont la même forme et possédant chacune une pluralité de régions d'émetteur (21) en un même nombre, les régions de base (22) et d'émetteur (21) des structures de transistor respectives étant formées à l'aide de la même configuration de matrice, et en ce que chacune des différentes configurations de câblage connecte un nombre sélectionné respectif, y compris zéro, des régions d'émetteur (21) de chaque structure de transistor du dispositif auquel la configuration de câblage se rapporte.

2. Procédé selon la revendication 1, où les régions d'émetteur (21) ont toutes des aires égales.

3. Procédé selon la revendication 1 ou 2, où on produit des caractéristiques en courant continu prédéterminées respectives pour des transistors des dispositifs respectifs, lorsque les structures de transistor des dispositifs respectifs sont câblés, et de façon que les densités de courant d'émetteur respectives des transistors des dispositifs respectifs soient sensiblement identiques, lorsque les dispositifs sont en utilisation.

0 029 369

# FIG. 1

$$\frac{I_1}{r_2} \approx \frac{I_2}{r_1}$$

# FIG. 2

$$\frac{I_1}{S_1} = \frac{I_2}{S_2}$$

0 029 369

# FIG. 3

# FIG. 4A

# FIG. 4B

# FIG. 4C

# FIG. 5

$I_2 = nI_1$

# FIG. 6

$I_2 = nI_1$

FIG. 7

FIG. 8A

FIG. 8B

# FIG. 8C

21' 21  21' 21  21' 21

# FIG. 9

26          27

27